## Europäisches Patentamt
## European Patent Office
## Office européen des brevets

(19)

(11) Veröffentlichungsnummer: **0 135 066**
**B1**

(12) **EUROPÄISCHE PATENTSCHRIFT**

(45) Veröffentlichungstag der Patentschrift: **19.09.90**

(51) Int. Cl.⁵: **H 03 H 17/02, H 03 G 3/00**

(21) Anmeldenummer: **84108829.7**

(22) Anmeldetag: **26.07.84**

(54) Übertragungsanordnung für digitale Signale.

(30) Priorität: **15.09.83 DE 3333275**

(43) Veröffentlichungstag der Anmeldung:
**27.03.85 Patentblatt 85/13**

(45) Bekanntmachung des Hinweises auf die
Patenterteilung:
**19.09.90 Patentblatt 90/38**

(84) Benannte Vertragsstaaten:
**AT DE FR GB NL**

(56) Entgegenhaltungen:
WO-A-84/03159
DE-A-2 840 471

IEEE TRANSACTIONS ON CIRCUITS AND
SYSTEMS, Band CAS-24, Nr. 5, Mai 1977, Seiten
277-279, IEEE, New York, US; H. SCHRÖDER:
"High word-rate digital filters with
programmable table look-up"

(73) Patentinhaber: **ANT Nachrichtentechnik GmbH**
**Gerberstrasse 33**
**D-7150 Backnang (DE)**

(72) Erfinder: **Göckler, Heinz, Dipl.-Ing.**
**Elbinger Strasse 52**
**D-7150 Backnang (DE)**

(74) Vertreter: **Wiechmann, Manfred, Dipl.-Ing.**
**ANT Nachrichtentechnik GmbH Gerberstrasse**
**33 Postfach 11 20**
**D-7150 Backnang (DE)**

(56) Entgegenhaltungen:
PROCEEDINGS OF EUSIPCO-80, FIRST
EUROPEAN SIGNAL PROCESSING
CONFERENCE, Lausanne, 16.-18. September
1980, Seiten 123-129, North-Holland Publishing
Co., Amsterdam, NL; H.W. SCHÜSSLER:
"Implementation of variable digital filters"

**Beschreibung**

Die Erfindung betrifft eine Übertragungsanordnung nach dem Oberbegriff des Patentanspruches 1. Eine solche Übertragungsanordnung ist bei der digitalen Filterung im allgemeinen, aber auch bei der Pegelstellung anwendbar, wobei Filterparameter (also ein Koeffizientensatz eines Übertragungsgliedes) während des Betriebes umschaltbar sein sollen. Als digitale Signale kommen Sprach-, Musik-, aber auch nicht hörbare Signale in Betracht.

Die einfachste Methode, die Übertragungsfunktion einer Übertragungsanordnung für digitale Signale im Betrieb zu ändern, besteht, darin, zwischen zwei Abtastzeitpunkten den gesamten Koeffizientensatz auszutauschen. Eine solche abrupte, momentane Umschaltung des Koeffizientensatzes führt aber ohne spezielle Maßnahmen für eine Störunterdrückung zu Störungen im Ausgangssignal der Übertragungsanordnung, und zwar—beispielsweise bei Audiosignalen—zu Störungen, die für das Gehör unangenehm sind. Es entstehen beispielsweise Knackgeräusche, die je nach vorliegender Koniguration und zufälliger Wahl das Umschaltzeitpunktes mehr oder weniger unangenehm in Erscheinung treten.

Es ist denkbar, solche Störungen durch Einschalten von Störunterdrückungsgliedern ind en Weg für die digitalen Signale zu reduzieren. Solche Lösungen haben sich aber als nicht voll befriedigend erwiesen, da sie auch das Nutzsignal in unerwünschter Weise beeinflussen.

Dagegen ist in einer parallelen Patentanmeldung zur vorliegenden von derselben Anmelderin, vom selben Erfinder und mit demselben Titel vorgeschlagen worden, parallel zum Übertragungsglied, dessen Koeffizientensatz umschaltbar sein sollte, einen zweiten Zweig mit einem zweiten digitalen Übertragungsglied vorzusehen. Wird eine Veränderung der Übertragungsfunktion des ersten Übertragungsgliedes gewünscht, so werden statt einer Änderung der Koeffizienten des ersten Übertragungsgliedes die Koeffizienten des zweiten Übertragungsgliedes auf die gewünschten Werte umgeschaltet. Die Ausgangsgröße des zweiten Übertragungsgliedes wird aber über Umschaltmittel erst dann an den Ausgang der Übertragungsanordnung weitergeleitet, wenn ein Diskriminator D, der um die Einschwingzeit des zweiten Übertragungsgliedes verzögert wirksam geschaltet wird, nach einem Vergleich der Ausgangsgrößen der beiden Übertragungsglieder die Umschaltung der Umschaltmittel bewirkt.

Diese vorgeschlagene Übertragungsanordnung erscheint noch in einigen Punkten verbesserungswürdig:

1. Während der Einschwingdauer müssen gleichzeitig zwei vollständige Übertragungsglieder zueinander parallel arbeiten, was im umschaltfreien Betrieb nicht der Fall ist; das bedeutet, daß der Hardware- oder Rechenaufwand nur, um die Koeffizientenumschaltung zur ermöglichen, verdoppelt werden muß.

2. Da die Umschaltung auf einen Zustand der Übertragungsanordnung mit kurzer oder langer Einschwingdauer erfolgen kann, muß sich (zur Vermeidung eines weiteren Aufwandes) die Verzögerungszeit bis zum Wirksamschalten des Diskriminators an der längsten Einschwingzeit orientieren. Die dadurch bedingte lange Umschaltdauer tritt dann bei allen Umschaltvorgängen auf, falls nicht die Verzögerungszeit mit zusätzlichem Aufwand an die jeweilige Einschwingdauer angepaßt wird.

3. Es gibt zwar bei der vorgeschlagenen Übertragungsanordnung keine Störungen der Ausgangssignale in Gestalt von Sprüngen und Spitzen, aber da die Koeffizientenumschaltung bei der vorgeschlagenen Übertragungsanordnung abrupt zu einem wohl definierten Zeitpunkt erfolgt, können sich immerhin noch Knickpunkte im zeitlichen Signalverlauf ergeben, was möglicherweise auch noch als störend empfunden wird.

Dementsprechend ist es Aufgabe der vorliegenden Erfindung, eine andere Möglickeit zur weitgehenden Vermeidung von Störungen im Signalverlauf bei Veränderung der Übertragungsfunktion einer Übertragungsanordnung während des Betriebes anzugeben.

Diese Aufgabe wird gelöst durch die Übertragungsanordnung mit den Merkmalen des Patentanspruches 1. Vorteilhafte Weiterbildungen sind in den Unteransprüchen angegeben. Die Erfindung kann also dadurch realisiert werden, daß dem Übertragungsglied über Umschaltmittel nacheinander Koeffizientensätze zugeordnet werden, die abwechselnd aus zwei Speichern mit wahlfreiem Zugriff kommen und als Zwischenkoeffizientensätze (gebildet durch Interpolationswerte zwischen einem Anfangs- und einem Endkoeffizientensatz) dafür sorgen, daß die Übertragungsfunktion des Übertragungsgliedes sich in kleinen Schritten von einer Anfangs- bis zu einer Endübertragungsfunktion verändert, ohne dabei Störungen hervorzurufen.

Damit ergeben sich folgende Vorteile:

1. Die Übertragungsanordnung benötigt während des Umschaltvorganges einen relativ geringen Mehraufwand an Hardware- bzw. Rechenaufwand gegenüber dem umschaltfreien Betrieb.

2. Die Umschaltdauer ist bei den am häufigsten vorkommenden Umschaltfällen wesentlichen kürzer als bei der anfangs beschriebenen, vorgeschlagenen Übertragungsanordnung zur anderweitigen Lösung der Aufgabe. Die Umschaltdauer ist nämlich abhängig von der Differenz zwischen dem Koeffizientensatz $c_0$ (geordnete Anordnung aller Koeffizienten, sogenannter Koeffizientenvektor) vor der Koeffizientenumschaltung und dem Koeffizientensatz $c_N$ nach Beendigung des Umschaltvorganges, also abhängig vom Koeffizienten-Differenzvektor $\Delta c = c_N - c_0$. Aufgrund dieser ohne zusätzlichen Aufwand

2

auftretenden Abhängigkeit ist die Umschaltdauer in den meisten Fällen kürzer als bei dem anderen Vorschlag.

3. Die Umschaltung erfolgt bei der Übertragungsanordnung nach der Erfindung allmählich, da in kleinsten Schritten, also verteilt über die gesamte Umschaltdauer. Dadurch werden Einschwingvorgänge bei nachfolgenden Systemen eher vermieden und bei Anwendung in der Tontechnik wird der Zuhörer auf die nicht abrupt geschaltete, neue Übertragungsfunktion der Übertragungsanordnung besser eingestimmt

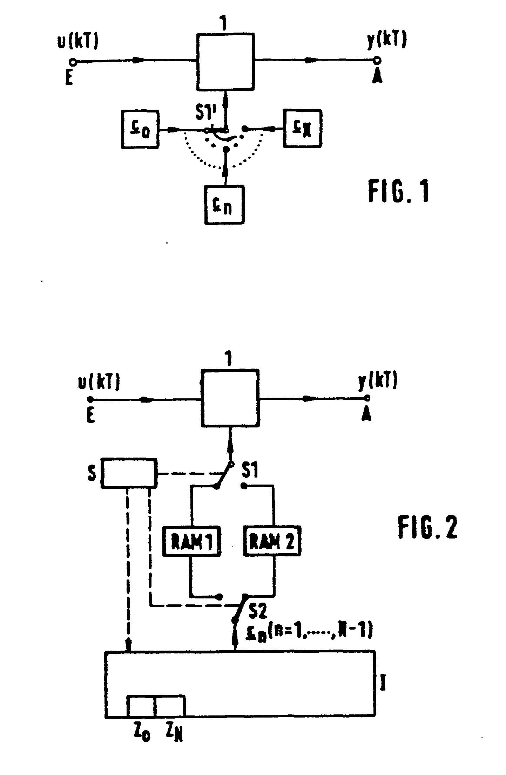

Anhand der Zeichnung wird die Erfindung näher erläutert (Fig. 1) und ein Ausführungsbeispiel (Fig. 2) beschrieben.

Bei der schematisch dargestellten Übertragungsanordnung nach Figur 1 ist zwischen einem Eingang E für das digitale Eingangssignal $u(kT)$ und dem Ausgang A der Übertragungsanordnung (mit dem digitalen Ausgangssignal $y(kT)$) ein Übertragungsglied 1 vorgesehen. Diesem können über Umschaltmittel S1' nacheinander unterschiedliche Koeffizientensätze zugeordnet werden, beginnend mit einem Anfangskoeffizientensatz $c_o$ über einen beliebigen (n-ten) Zwischenkoeffizientensatz $c_n$ bis zu einem Endkoeffizientensatz $c_N$. Die Umschaltung des Übertragungsgliedes 1 vom Anfangskoeffizientensatz auf den Endkoeffizientensatz erfolgt über $N-1$ Zwischenstufen, mittels derer Zwischenkoeffizientensätze $c_n$ eingeschaltet werden. Dabei werden diese Zwischenkoeffizientensätze durch bevorzugt lineare Interpolation zwischen dem Anfangs- und dem Endkoeffizientensatz ermittelt. Dies geschieht für einen beliebigen, nämlich den n-ten Zwischenkoeffizientensatz nach der Gleichung:

$$c_n = c_o + n(c_N - c_o)/N = c_o + n\Delta c/N \tag{1}$$

mit $n = 1, ..., N-1, N$.

Darüberhinaus ist es möglich, jeden Koeffizientensatz mehrmahls, nämlich M mal zu verwenden. Folglich wird für den Umschaltvorgang insgesamt die Umschaltdauer

$$t_u = N \, M \, T$$

benötigt, wobei $T = 1/f_A$ die Abtastperiode, $f_A$ die Abtastfrequenz und N die Zwischenstufenzahl ist.

Für die Festlegung der Parameter M und N gilt folgendes:

Haltedauer M T: Werden die Zwischenkoeffizientensätze gemäß Gleichung (1) berechnet, so können mit ihnen im Verlauf des Umschaltvorganges Übertragungsfunktionen auftreten, die weit- ab von denen liegen, die mit dem Anfangs- bzw. mit dem Endkoeffizientensatz auftreten, selbst wenn der Koeffizientendifferenzvektor $\Delta c$ nicht sehr groß ist. Manche Zwischenkoeffizientensätze können sogar durchaus systemtheoretisch instabile Filter repräsentieren. Aus diesem Grunde sollte die ein ganzzahliges Vielfaches der Abtastperiode T beanspruchende Haltedauer M T möglichst klein, bevorzugt $M = 1$ sein, damit während des Umschaltvorganges nicht möglicherweise ungünstige Einschwingvorgänge bei der laufend neu mit unterschiedlichen Zwischenkoeffizientensätzen gebildeten Übertragungsanordnung angeregt werden.

Zwischenstufenzahl N: Der Übergang von Anfangskoeffizientensatz zum Endkoeffizientensatz erfolgt um so fließender, störungsärmer (bzw. -frei) und unabhängiger vom jeweiligen Umschaltzeitpunkt $t_o$, je größer die Zwischenstufenzahl N ist. Diese Stufenzahl ist nach oben aber aus zwei Gründen begrenzt:

a) Für die Umschaltdauer $t_u$ wird im allgemeinen ein maximalwert $t_{u\,max}$ vorgeschrieben, womit aus Gleichung (2) folgt:

$$N_{max} = \frac{1}{M} \cdot \frac{t_{u\,max}}{T}$$

b) Der Anfangs- und der Endkoeffizientensatz liegen in quantisierter Form mit begrenzter Koeffizientenwortlänge vor. Die kleinste darstellbare Einheit sei die Quantisierungsstufe Q. Mit dem Anfangs- und dem Endkoeffizientensatz sind auch der Koeffizientensatz-Differenzvektor $\Delta c$ und somit der Korrekturvektor $\Delta c/N$ in ihrer darstellbaren Genauigkeit begrenzt. Dabei ist Festkommaarithmetik angenommen; bei Gleitkommaarithmetik gelten diese Überlegungen in modifizierter Form. Ist nun die betragsmäßig kleinste, von Null abweichende Komponente von $\Delta c$ gegeben durch $L \cdot Q$ (mit $L = 1, 2, ...$), so darf die Zahl N maximal $N = L$ sein, falls der Quotient (Korrekturvektor) $\Delta c/N$ einem Betragsschneiden unterzogen wird; wird $\Delta c/N$ gerundet, so gilt $N \leq 2L$.

Dadurch nämlich, daß in den Fällen

Betragsschneiden für den Korrekturvektor: $N \leq L$           (4a)

Runden für den Korrekturvektor: $N \leq 2L$           (4b)

bleibt, wird keine der Komponenten des Korrekturvektors $\Delta c/N$ identisch zu Null. Das Null-Werden wäre nämlich unzulässig, da dann genau diese Korrekturkomponente mit ihrem Wert aufgrund der endlichen Darstellungsgenauigkeit keinen Beitrag zur Koeffizientensatz-Interpolation liefern würde. Am Ende des stufenweisen Umschaltvorganges müßte daher diese Komponente vom Anfangs- abrupt auf den Endkoeffizientensatz gesetzt werden, was u.U. Anlaß zu Störungen geben könnte.

Während also die Haltedauer MT möglichst klein, vorzugsweise M=1 gewählt werden sollte, ist die Stufenzahl N möglichst groß zu wählen, allerdings begrenzt durch $N_{max}$ willkürlich vorgebbar) oder durch die kleinste Komponente des Koeffizientensatz-Differenzvektors $\Delta c$ und die Quantisierungsstufe Q gemäß Gleichung 4; dabei wird aber $N_{max}$ bei der Wahl der Stufenzahl N nur dann entscheidend, wenn der Wert von N gemäß Gleichung (4) größer als $N_{max}$ ist.

Eine realisierungsgünstige Wahl von N ist gegeben, wenn N eine Potenz von 2 ist, also $N=2^i$ (i gleich ganze Zahl). Dann lassen sich die Multiplikationen zur Berechnung der Komponenten des Korrekturvektors $\Delta c/N=\Delta c \cdot 2^{-i}$ durch die entsprechende Anzahl von Schiebeoperationen ersetzen.

Da aufgrund der vorangegangenen Überlegungen die N-fache Addition quantisierter Korrekturvektoren zu dem Anfangskoeffizientensatz gemäß Gleichung (1) nicht genau auf den Endkoffizientensatz führen wird, erfolgt diese Akkumulation sinnvollerweise nur für n=1,..., N−1, während ab dem N-ten Schritt der bekannte Endkoeffizientensatz unmittelbar verwendet wird.

Mit diesen Ausführungen wird nun auch deutlich, daß die maximale Umschaltdauer bestimmt ist durch $\Delta c$ bzw. L, also durch den (kleinsten) Unterschied zwischen dem Anfangs- und dem Endkoeffizientensatz. Sie ist im Gegensatz zu der vorgeschlagenen anderen Übertragungsanordnung unabhäning von der Einschwingdauer des Übertragungsgliedes bzw. dessen Bandbreite.

Figur 2 zeigt ein Blockschaltbild eines bevorzugten Ausführungsbeispieles. Statt der die Zusammenhänge nur andeutenden mehrfachen Umschaltmittel S1' in Figur 1 sind als Umschaltmittel in Fig. 2 zwei Umschalter S1 und S2 vorgesehen, die gegensinnig zueinander und synchron eine Verbindung zu zwei parallel zueinander liegenden Zweigen mit je einem Speicher mit wahlfreiem Zugriff RAM1 bzw. RAM2 herstellen. Die Umschalter schalten jeweils nach einer Haltedauer MT um und werden von Steuermitteln S gesteuert, die auch zur Steuerung von Interpolationsmitteln I dienen. Diese Interpolationsmittel I liefern die Zwischenkoeffizientensätze als Interpolationswerte zwischen dem Anfangs- und Enkoeffizientensatz, der in einem Zwischenspeicher $Z_o$ bzw. $Z_N$ festgehalten ist. Die Speicher RAM1 und RAM2 werden abwechselnd mit einem Zwischenkoeffizientensatz geladen. Während ein Speicher über den Umschalter S2 geladen wird, ordnet der andere den in ihm gespeicherten Zwischenkoeffizientensatz über den Umschalter S1 dem Übertragungsglied 1 zu.

## Patentansprüche

1. Digitale Übertragungsanordnung, die mit kodierten abtastproben arbeitet und deren Übertragungsfunktion ohne Betriebsunterbrechung ausgehend von einer Anfangsübertragungsfunktion störungsarm bis zu einer Endübertragungsfunktion verändert werden kann, mit Umschaltmitteln für die jeweils dem Übertragungsglied (1) der Übertragungsanordnung zuzuordnenden Übertragungskoeffizienten zur Umschaltung von einem vorgegebenen Anfangskoeffizientensatz auf einen vorgegebenen Endkoeffizientensatz, dadurch gekennzeichnet,

a) daß die Umschaltmittel (S1') ausgebildet sind zur Einschaltung von N−1 Zwischenkoeffizientensätzen $(c_n)$ zwischen dem Anfangs- und dem Endkoeffizientensatz, wobei N eine natürliche Zahl größer als 1 ist,

b) daß für die Ermittlung der Zwischenkoeffizientensätze Interpolationsmittel (I) vorgesehen sind zur Lieferung von Interpolationswerten, die bevorzugt linear interpoliert zwischen dem Anfangs- und dem Endkoeffizientensatz liegen und als Zwischenkoeffizientensätze $(c_n)$ dienen,

c) daß Steuermittel (S) vorgesehen sind sowohl zur Steuerung der Interpolationsmittel (I) als auch zur Verzögerung der Zuordnung des Endkoeffizientensatzes zum Übertragungsglied (1) solange, bis alle Zwischenkoeffizientensätze $(c_n)$ nacheinander jeweils mindestens einmal zugeordnet worden sind.

2. Übertragungsanordnung nach Anspruch 1, dadurch gekennzeichnet, daß jeder Zwischenkoeffizientensatz $(c_n)$ nur einmal für die Zuordnung zu dem Übertragungsglied (1) vorgesehen ist.

3. Übertragungsanordnung nach Anspruch 1 oder 2, dadurch gekennzeichnet, daß N bei linearer Interpolation höchstens so groß ist, daß

a) weder die vorgegebene zulässige Umschaltdauer (tu) überschritten ist, die sich aus dem Produkt aus N der Anzahl (M) der Zuordnungen je Zwischenkoeffizientensatz $(c_n)$ und der Abtastperiode (T) ergibt,

b) noch N das Produkt aus einer Konstanten und derjenigen Anzahl (L) von Quantisierungsstufen überschreitet, welche die betragsmäßig kleinste Komponente des Differenzvektors zwischen dem Anfangs- und dem Endkoeffizientensatz aufweist, wobei die Konstante gleich 1 ist, wenn bei der Ermittlung der Zwischenkoeffizienten Betragsschneiden angewendet wird, während die Konstante gleich 2 ist, wenn bei der Ermittlung der Zwischenkoeffizienten gerundet wird.

4. Übertragungsanordnung nach Anspruch 3, dadurch gekennzeichnet, daß N möglichst groß gewählt ist.

5. Übertragungsanordnung nach Anspruch 3 oder 4, dadurch gekennzeichnet, daß N eine Potenz von 2 mit ganzzahligem Exponenten ist.

6. Übertragungsanordnung nach einem der vorangehenden Ansprüche, dadurch gekennzeichnet, daß zwischen den Interpolationsmitteln (I) und dem Übertragungsglied (1) zwei abwechselnd und gegensinnig mit den Interpolationsmitteln bzw. dem Übertragungsglied verbundene Speicher (RAM1, RAM2) mit wahlfreiem Zugriff vorgesehen sind.

# EP 0 135 066 B1

## Revendications

1. Agencement de transmission numérique, qui opère avec des échantillons codés et dont la fonction de transfert peut, sans interruption d'exploitation, être changée, avec peu de perturbations, d'une fonction de transfert initiale jusqu'à une fonction de transfert finale, avec des moyens de commutation pour les coefficients de transmission attribuées à chaque fois à l'organe de transmission (1) de l'agencement de transmission, pour la commutation d'un ensemble prédéterminé de coefficients initiaux, à un ensemble prédéterminé de coefficients finals, caractérisé

a) par le fait que les moyens de commutation (S1') sont conçus et réalisés pour l'application de N−1 ensembles de coefficients intermédiaires (c_n) entre l'ensemble de coefficients initiaux et l'ensemle de coefficients finals, N étant un nombre naturel supérieur à 1,

b) par le fait que, pour l'établissement des ensembles de coefficients intermédiaires, des moyens d'interpolation (I) sont prévus pour fournir des valeurs d'interpolation qui, interpolées de préférence linéairement, sont comprises entre l'ensemble de coefficients initiaux et l'ensemble de coefficients finals et servent d'ensembles de coefficients intermédiaires (c_n),

c) par le fait que des moyens de commande (S) sont prévus aussi bien pour la commande des moyens d'interpolation (I) que pour le retardement de l'attribution de l'ensemble de coefficients finals à l'organe de transmission (1), jusqu'à ce que tous les ensembles de coefficients intermédiaires (c_n) aient été attribués successivement, chacun au moins une fois.

2. Agencement de transmission selon revendication 1, caractérisé par le fait que chaque ensemble de coefficients intermédiaires (c_n) n'est prévu qu'une fois pour l'attribution à l'organe de transmission (1).

3. Agencement de transmission selon revendication 1 ou 2, caractérisé par le fait que, avec interpolation linéaire, N este au maximum tel que

a) il n'y ait ni dépassement de la durée de commutation admissible prédéterminée (tu), donnée par le produit de N par le nombre (N) des attributions pour chaque ensemble de coefficients intermédiaires (c_n) et par la période d'échantillonnage (T),

b) ni dépassement, par N, du produit d'une constante par le nombre (L) d'échelons de quantification, que présente la composante la plus petite en valeur absolue du vecteur différence entre l'ensemble de coefficients initiaux et l'ensemble de coefficients finals, la constante étant égale à 1 si, lors de l'établissement des coefficients intermédiaires, on applique une coupure de valeur, tandis que la constante est égale à 2 si, lors de l'établissement des coefficients intermédiaires, on arrondit.

4. Agencement de transmission selon revendication 3, caractérisé par le fait que N est choisi aussi grand que possible.

5. Agencement de transmission selon revendication 3 ou 4, caractérisé par le fait que N est une puissance de 2, avec exposant entier.

6. Agencement de transmission selon l'une des revendications précédentes, caractérisé par le fait qu'il est prévu, entre les moyens d'interpolation (I) et l'organe de transmission (1), deux mémoires à accès aléatoire (RAM1, RAM2) reliées alternativement, dans des sens opposés, aux moyens d'interpolation ou encore à l'organe de transmission.

## Claims

1. Digital transmission arrangement, which operates with coded scanning samples and the transmission function of which can without interruption of operation be varied from an initial transmission function with little interference to a final transmission function, with change-over switch means for the transmission co-efficients respectively to be associated with the transmission member (1) of the transmission arrangement for switching over from a prescribed initial co-efficient set to a prescribed final co-efficient set, characterised thereby,

a) that the change-over switch means (S1') are constructed for the switching-in of N−1 intermediate co-efficient sets (c_n) between the initial co-efficient set and the final co-efficient set, wherein N is a natural number greater than 1,

b) that for the determination of the intermediate co-efficient sets, interpolation means (I) are provided for the supply of interpolation values which preferably lie linearly interpolated between the initial co-efficient set and the final co-efficient set and serve as intermediate co-efficient sets (c_n), and

c) that control means (S) are provided for the control of the interpolation means (I) as well as also for the delay of the association of the final co-efficient set with the transmission member (1) until all intermediate co-efficient sets (c_n) have each been associated one after the other at least once.

2. Transmission arrangement according to Claim 1, characterised thereby, that each intermediate co-efficient set (c_n) is provided only once for the association with the transmission member (1).

3. Transmission arrangement according to Claim 1 or 2, characterised thereby, that N in the case of linear interpolation is chosen to be at most so great that

a) neither the prescribed permissible switch-over duration (tu) is exceeded, which results from the product of N, the number (M) of the associations per intermediate co-efficient set (c_n) and the scanning period (T),

5

b) nor N exceeds the product of a constant and that number (L) of quantisation stages, which in terms of magnitude displays the smallest component of the difference vector between the initial co-efficient set and the final co-efficient set, wherein the constant is equal to 1, when amplitude slicing is applied in the determination of the intermediate co-efficients, whilst the constant is equal to 2, when rounding-off is done in the determination of the intermediate co-efficients.

4. Transmission arrangement according to Claim 3, characterised thereby, that N is chosen to be as large as possible.

5. Transmission arrangement according to Claim 3 or 4, characterized thereby, that N is a power of 2 with integral exponents.

6. Transmission arrangement according to one of the preceding claims, characterised thereby, that two stores (RAM1, RAM2) with freely selectable access are provided between the interpolation means (I) and the transmission member (1) and connected alternatively and in opposite sense with the interpolation means and the transmission member respectively.

u(kT)        **1**        y(kT)

E        A

S1'

$\underline{c}_0$        $\underline{c}_N$

$\underline{c}_n$

**FIG. 1**

u(kT)        **1**        y(kT)

E        A

S        S1

**FIG. 2**

RAM 1        RAM 2

S2

$\underline{c}_n (n=1,\ldots,N-1)$

I

$Z_0$    $Z_N$